# EUROPEAN PATENT APPLICATION

(11) **EP 2 280 432 A1**
(43) Date of publication of application: **02.02.2011**
(21) Application number: 09750602.6
(22) Date of filing: 20.05.2009
(51) Int. Cl.: H01L 35/32, H01L 35/34

(54) **THERMOELECTRIC CONVERSION MODULE AND PROCESS FOR PRODUCING THERMOELECTRIC CONVERSION MODULE**

(30) Priority: 23.05.2008 JP 2008135656
(71) Applicant: Murata Manufacturing Co. Ltd., Kyoto 617-8555 (JP)
(72) Inventor: NAKAMURA Takanori, Nagaokakyo-shi Kyoto 617-8555 (JP); MATSUMOTO Shuji, Nagaokakyo-shi Kyoto 617-8555 (JP)
(74) Representative: Alder, Ettie-Ann
(86) International application number: PCT/JP2009/059268
(87) International publication number: WO 2009/142240

(57) **Abstract**

Disclosed herein are a highly-reliable thermoelectric conversion module which has a structure formed by bonding a P-type thermoelectric conversion material and an N-type thermoelectric conversion material together with an insulating material interposed therebetween, and is capable of reliably ensuring insulation between the bonding surfaces of the P-type thermoelectric conversion material and the N-type thermoelectric conversion material, and achieves a high occupancy of thermoelectric conversion elements, and a method for producing such a thermoelectric conversion module.

The thermoelectric conversion module is formed by bonding a P-type thermoelectric conversion material 1 and an N-type thermoelectric conversion material 2 together with an insulating material 11 containing spherical ceramic grains 11a having a 3CV value, which is an index of grain size dispersion, of 20% or less interposed therebetween. Further, the P-type thermoelectric conversion material 1 and the N-type thermoelectric conversion material 2 are electrically connected to each other in a region other than a region where the P-type thermoelectric conversion material 1 and the N-type thermoelectric conversion material 2 are bonded together with the insulating material 11 interposed therebetween.

The spherical ceramic grains 11a have an average grain size of 0.05 to 0.6 mm.

The insulating material 11 is an insulating glass material.

## Description

### TECHNICAL FIELD

The present invention relates to a thermoelectric conversion module and a method for producing the same. More specifically, the present invention relates to a thermoelectric conversion module which comprises a P-type thermoelectric conversion material and an N-type thermoelectric conversion material bonded together with an insulating material interposed therebetween and which has a high occupancy of the thermaelectric conversion materials per area and a method for producing such a thermoelectric conversion module.

### BACKGROUND ART

In recent years, carbon dioxide reduction has become a critical issue to prevent global warming. Therefore, attention is being given to thermoelectric conversion elements capable of directly converting heat to electricity as one of effective means for waste heat recovery.

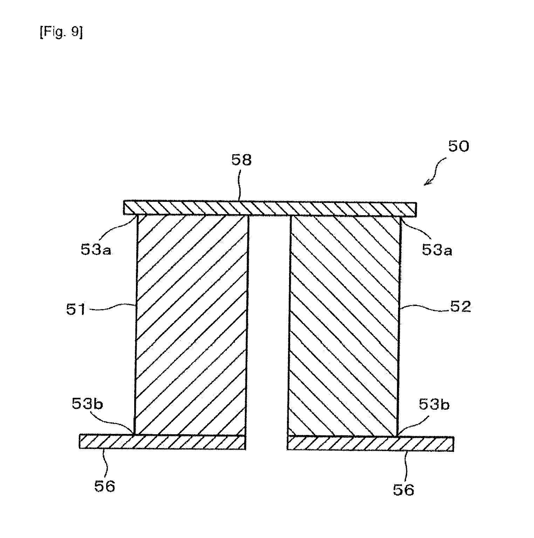

As an example of a conventional thermoelectric conversion element, a thermoelectric conversion element 50 shown in Fig. 9 is known. As shown in Fig. 9, the thermoelectric conversion element 50 includes a P-type thermoelectric conversion material 51, an N-type thermoelectric conversion material 52, low-temperature electrodes 56, and a high-temperature electrode 58.

In the thermoelectric conversion element 50, the two types of thermoelectric conversion materials 51 and 52 are provided for energy conversion from heat to electricity. The thermoelectric conversion materials 51 and 52 are connected to the low-temperature electrodes 56 at their respective low-temperature junctions 53b. The low-temperature junctions 53b are provided by the end faces of the thermoelectric conversion materials 51 and 52 located on the low-temperature electrode side. Further, the thermoelectric conversion materials 51 and 52 are also connected to the high-temperature electrode 58 at their respective high-temperature junctions 53a, and the high-temperature electrode 58 connects the thermoelectric conversion materials 51 and 52 to each other. The high-temperature junctions 53a are provided by the end faces of the thermoelectric conversion materials 51 and 52 located on the high-temperature electrode side.
When a temperature difference is applied between the high-temperature junctions 53a and the low-temperature junctions 53b of the thermoelectric conversion element 50, electromotive force is generated by the Seebeck effect, and therefore electricity can be extracted from the thermoelectric conversion element 50.

Meanwhile, the electric-generating capacity of a thermoelectric conversion element depends on the thermoelectric conversion characteristics of materials used or a temperature difference applied to the element, but is also significantly influenced by the occupancy of thermoelectric conversion materials (i.e., by the proportion of the area of a portion occupied by thermoelectric conversion materials in a plane perpendicular to a direction in which a temperature difference is applied to the thermoelectric conversion element). Therefore, the electric-generating capacity of a thermoelectric conversion element per unit area can be increased by increasing the occupancy of the thermoelectric conversion materials.

However, the conventional thermoelectric conversion element 50 has a structure in which an insulating gap layer is provided between the two thermoelectric conversion materials 51 and 52. Therefore, there is a natural limit to the extent to which the occupancy of the thermoelectric conversion materials can be increased.

In order to solve such a problem, a thermoelectric conversion module shown in Figs. 10(a) and 10(b) (see, for example, Patent Document 1) has been proposed. As shown in Figs. 10(a) and 10(b), the thermoelectric conversion module is formed by bonding the P-type thermoelectric conversion material 51 and the N-type thermoelectric conversion material 52 together with an insulating layer 61 interposed therebetween, and electrodes 62 are provided on the upper and lower surfaces of the P-type and N-type thermoelectric conversion materials 51 and 52 to electrically connect the P-type and N-type thermoelectric conversion materials 51 and 52 to each other.

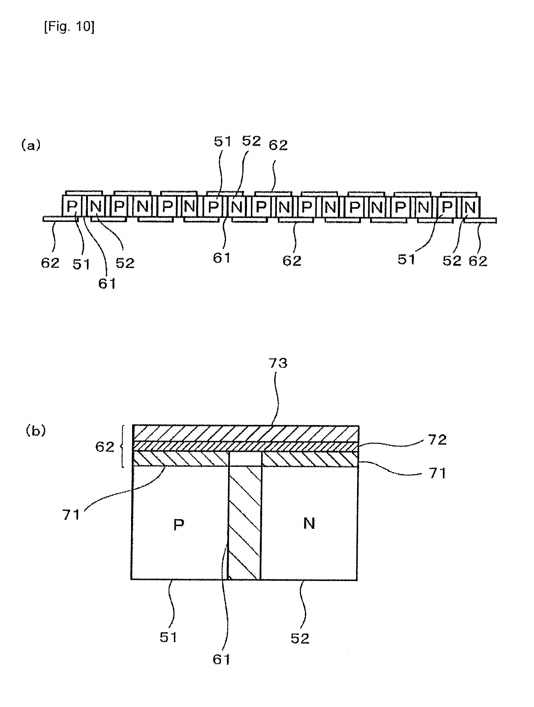

More specifically, as shown in Fig. 10(b), the side surface (bonding surface) of the P-type thermoelectric conversion material 51 and the side surface (bonding surface) of the N-type thermoelectric conversion material 52 are bonded together with the insulating layer 61 interposed therebetween, and the electrode 62 is provided on the upper surfaces of the P-type and N-type thermoelectric conversion materials 51 and 52 to electrically connect the P-type and N-type thermoelectric conversion materials 51 and 52 to each other. The electrode 62 comprises carbon electrodes 71, a nickel-based wax 72, and a molybdenum electrode 73, and the nickel-based wax 72 and the molybdenum electrode 73 are stacked in this order on the carbon electrodes 71 provided on the upper surfaces of the P-type and N-type thermoelectric conversion materials 51 and 52, respectively.
The insulating layer 61 is made of an electric insulating material obtained by dispersing ceramic grains in a glass matrix.

Since the thermoelectric conversion module constituted as described above is formed by bonding the P-type thermoelectric conversion material 51 and the N-type thermoelectric conversion material 52 together with the insulating layer 61 interposed therebetween, there is no need to provide space between the P-type thermoelectric conversion material 51 and the N-type thermoelectric conversion material 52. This makes it possible to achieve a high occupancy of the thermoelectric conversion materials, thereby improving electric-generating capacity per unit area.
Patent Document 1: JP-A-2000-286467

### DISCLOSURE OF THE INVENTION

### PROBLEMS TO BE SOLVED BY THE INVENTION

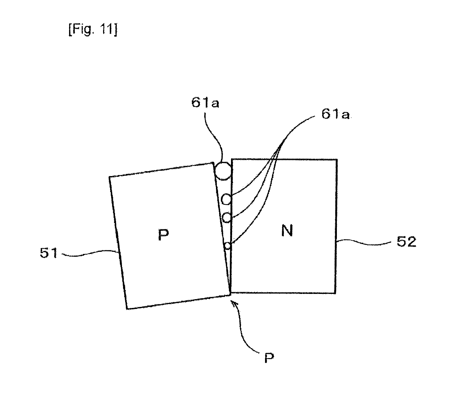

However, there is a case where such a conventional thermoelectric conversion module formed by bonding the P-type and N-type thermoelectric conversion materials 51 and 52 together using an electric insulating material obtained by dispersing ceramic grains in a glass matrix is poor in reliability. This is because if the grain size distribution of ceramic grains 61 a is wide, as schematically shown in Fig. 11, there is a problem that the bonding surfaces of the P-type and N-type thermoelectric conversion materials 51 and 52 are not arranged parallel to each other and therefore come into contact with each other at their ends (in a position represented as a point P in Fig. 11), thereby causing a short circuit.

Further, if the bonding surfaces of the P-type and N-type thermoelectric conversion materials 51 and 52 bonded together with the insulating layer 61 interposed therebetween are not arranged parallel to each other, there is also a problem that the P-type and N-type thermoelectric conversion materials 51 and 52 cannot be placed in proper alignment and therefore the occupancy of the thermoelectric conversion materials cannot be improved.

Under the circumstances, it is an object of the present invention to provide a highly-reliable thermoelectric conversion module which has a structure formed by bonding a P-type thermoelectric conversion material and an N-type thermoelectric conversion material together with an insulating material interposed therebetween, and is capable of ensuring insulation between the bonding surfaces of the P-type thermoelectric conversion material and the N-type thermoelectric conversion material, and achieves a high occupancy of the thermoelectric conversion materials. It is also an object of the present invention to provide a method for producing such a thermoelectric conversion module.

### SOLUTION TO THE PROBLEMS

In order to solve the above problems, the thermoelectric conversion module of the present invention includes:
a P-type thermoelectric conversion material;
an N-type thermoelectric conversion material; and
an insulating material containing spherical ceramic grains having a 3CV value, which is an index of particle size dispersion, of 20% or less, wherein the P-type thermoelectric conversion material and the N-type thermoelectric material are bonded together with the insulating material interposed therebetween, and wherein in a region other than a region where the P-type thermoelectric conversion material and the N-type thermoelectric conversion material are bonded together with the insulating material interposed therebetween, the P-type thermoelectric conversion material and the N-type thermoelectric conversion material are electrically connected to each other.

It is desirable that the spherical ceramic grains have an average grain size of 0.05 to 0.6 mm.

It is also desirable that the insulating material is an insulating glass material.

The method for producing a thermoelectric conversion module of the present invention is a method for producing a thermoelectric conversion module including a P-type thermoelectric conversion material and an N-type thermoelectric conversion material which are bonded together with an insulating material interposed therebetween and are electrically connected to each other in a region other than a region where they are bonded together with the insulating material interposed therebetween, the method including the steps of:
preparing a P-type thermoelectric conversion material and an N-type thermoelectric conversion material;
applying an insulating material paste onto at least one of bonding surfaces of the P-type thermoelectric conversion material and the N-type thermoelectric conversion material to be bonded together with the insulating material interposed therebetween;
when the insulating material paste is applied onto both the bonding surfaces to be bonded together, attaching spherical ceramic grains having a 3CV value, which is an index of grain size dispersion, of 20% or less to at least one of the bonding surfaces so that the spherical ceramic grains are held by the insulating material paste, or when the insulating material paste is applied onto only one of the bonding surfaces to be bonded together, attaching spherical ceramic grains having a 3CV value, which is an index of grain size dispersion, of 20% or less to the one bonding surface onto which the insulating material paste is applied so that the spherical ceramic grains are held by the insulating material paste; and
sticking the P-type thermoelectric conversion material and the N-type thermoelectric conversion material together with the insulating material paste containing the spherical ceramic grains interposed therebetween and then bonding the P-type thermoelectric conversion material and the N-type thermoelectric conversion material together by thermal treatment.

It is desirable that the spherical ceramic grains have an average grain size of 0.05 to 0.6 mm.

It is preferable that the insulating material is an insulating glass material.

### ADVANTAGES OF THE INVENTION

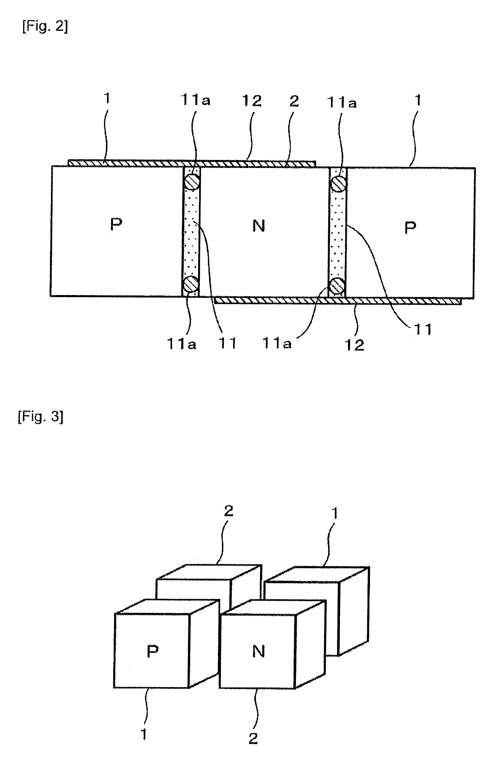

The thermoelectric conversion module according to the present invention is formed by bonding a P-type thermoelectric conversion material and an N-type thermoelectric conversion material together with an insulating material containing spherical ceramic grains having a 3CV value, which is an index of grain size dispersion, of 20% or less interposed therebetween. Therefore, the P-type thermoelectric conversion material and the N-type thermoelectric conversion material can be arranged with no space therebetween. This makes it possible to provide a thermoelectric conversion module capable of achieving a high occupancy of the thermoelectric conversion materials and a high electric-generating capacity per unit area.
Further, the spherical ceramic grains constituting the insulating material have a 3CV value of 20% or less (i.e., have a narrow grain size distribution). Therefore, as schematically shown in Fig. 2, the bonding surfaces of a P-type thermoelectric conversion material 1 and an N-type thermoelectric conversion material 2 are allowed to be arranged substantially parallel to each other so as to be opposed to each other and spaced at substantially equal distances at all points, and thus, a plurality of the P-type thermoelectric conversion material 1 and a plurality of the N-type thermoelectric conversion material 2 can be reliably placed in proper alignment. This makes it possible to provide a highly-reliable thermoelectric conversion module having a high occupancy of the thermoelectric conversion materials.

When the spherical ceramic grains have an average grain size of 0.05 to 0.6 mm, the P-type thermoelectric conversion material and the N-type thermoelectric conversion material can be more reliably bonded together so that the bonding surfaces of the P-type thermoelectric conversion material and the N-type thermoelectric conversion material are arranged substantially parallel to each other so as to be opposed to each other and spaced at substantially equal distances at all points. This makes it possible to more reliably provide a highly-reliable thermoelectric conversion module having a high occupancy of the thermoelectric conversion materials.

Therefore, the spherical ceramic grains preferably have an average grain size of 0.05 to 0.6 mm. If the average grain size of the spherical ceramic grains is less than 0.05 mm, it is difficult to maintain an adequate distance between the bonding surfaces. On the other hand, if the average grain size of the spherical ceramic grains exceeds 0.6 mm, the distance between the opposing bonding surfaces of the thermoelectric conversion materials becomes too large, and therefore the effect of improving the occupancy of thermoelectric conversion materials cannot be sufficiently obtained.

Further, when the insulating material is an insulating glass material, the P-type thermoelectric conversion material and the N-type thermoelectric conversion material can be reliably bonded together while insulation between the P-type thermoelectric conversion material and the N-type thermoelectric conversion material is ensured. This makes it possible to provide a highly-reliable thermoelectric conversion module.

According to the method for producing a thermoelectric conversion module of the present invention, an insulating material paste is applied onto at least one of the bonding surfaces of a P-type thermoelectric conversion material and an N-type thermoelectric conversion material to be bonded together with an insulating material interposed therebetween. When the insulating material paste is applied onto both the bonding surfaces to be bonded together, spherical ceramic grains having a 3CV value of 20% or less are attached to at least one of the bonding surfaces so as to be held by the insulating material paste. When the insulating material paste is applied onto only one of the bonding surfaces to be bonded together, spherical ceramic grains having a 3CV value of 20% or less are attached to the one bonding surface, onto which the insulating material paste has been applied, so as to be held by the insulating material paste. Then, the P-type thermoelectric conversion material and the N-type thermoelectric conversion material are stuck together with the insulating material paste containing the spherical ceramic grains, and are then bonded together by heat treatment. Therefore, the P-type thermoelectric conversion material and the N-type thermoelectric conversion material can be arranged with no space therebetween while the bonding surfaces of the P-type thermoelectric conversion material and the N-type thermoelectric conversion material are reliably prevented from coming into direct contact with each other. This makes it possible to efficiently produce a highly-reliable thermoelectric conversion module having a high occupancy of the thermoelectric conversion materials.

When the spherical ceramic grains have an average grain size of 0.05 to 0.6 mm, the P-type thermoelectric conversion material and the N-type thermoelectric conversion material can be bonded together so that the bonding surfaces of the P-type thermoelectric conversion material and the N-type thermoelectric conversion material are arranged substantially parallel to each other so as to be opposed to each other and spaced at substantially equal distances at all points. This makes it possible to more reliably produce a highly-reliable thermoelectric conversion module having a high occupancy of the thermoelectric conversion materials.

When the insulating material is an insulating glass material, the P-type thermoelectric conversion material and the N-type thermoelectric conversion material can be reliably bonded together while insulation between the P-type thermoelectric conversion material and the N-type thermoelectric conversion material is ensured. This makes it possible to efficiently produce a highly-reliable thermoelectric conversion module having a high occupancy of the thermoelectric conversion materials.

### BRIEF DESCRIPTION OF THE DRAWINGS

Fig. 1 is a plan view of a thermoelectric conversion module according to an example of the present invention.
Fig. 2 is a front sectional view showing the structure of a principal part of the thermoelectric conversion module shown in Fig. 1.
Fig. 3 is a diagram showing one step of a method for producing the thermoelectric conversion module according to the example of the present invention.
Fig. 4 is a diagram showing another step of the method for producing the thermoelectric conversion module according to the example of the present invention.
Fig. 5 is a diagram showing the step of arranging spherical ceramic grains (spherical zirconium oxide beads) on a glass paste applied onto side surfaces of thermoelectric elements in the method for producing the thermoelectric conversion module according to the example of the present invention.
Fig. 6 is a diagram showing the step of bonding the thermoelectric elements together in the method for producing the thermoelectric conversion module according to the example of the present invention.
Fig. 7 is a diagram showing the step of connecting the thermoelectric elements to each other in series by electrodes in the method for producing the thermoelectric conversion module according to the example of the present invention.
Fig. 8 is a schematic plan view of a thermoelectric conversion module according to a comparative example.
Fig. 9 is a diagram of a conventional thermoelectric conversion module.
Fig. 10(a) is a plan view of another conventional thermoelectric conversion module and Fig. 10(b) is an expanded view of a principal part of the conventional thermoelectric conversion module shown in Fig. 10(a).
Fig. 11 is a diagram for explaining a problem of the conventional thermoelectric conversion module shown in Fig. 9.

### DESCRIPTION OF REFERENCE SIGNS

- 1: thermoelectric element (P-type thermoelectric conversion material)
- 2: thermoelectric element (N-type thermoelectric conversion material)
- 11a: spherical ceramic grain
- 11: insulating material (glass-based material)
- 12: electrode

### BEST MODE FOR CARRYING OUT THE INVENTION

Hereinbelow, the present invention will be described in more detail with reference to the following example.

### EXAMPLES

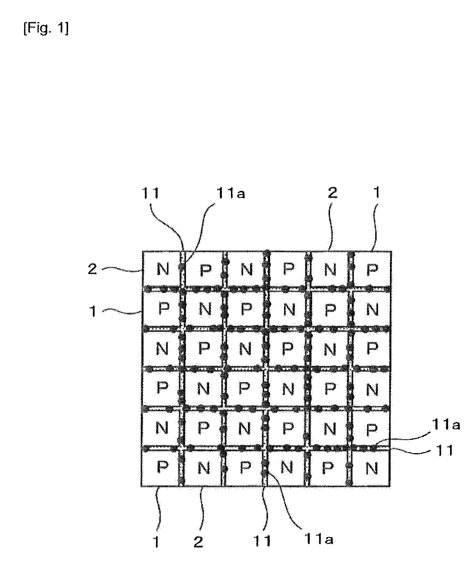

Fig. 1 is a plan view schematically showing the structure of a thermoelectric conversion module according to one example of the present invention, and Fig. 2 is an expanded front sectional view of a principal part of the thermoelectric conversion module shown in Fig. 1.
As shown in Figs. 1 and 2, the thermoelectric conversion module according to the present invention is formed by bonding thermoelectric elements (P-type thermoelectric conversion material 1 and N-type thermoelectric conversion material 2) together with an insulating material (in this example, an insulating glass material) 11 containing spherical ceramic grains 11a having a 3CV value, which is an index of grain size dispersion, of 20% or less and an average grain size of, for example, 0.05 to 0.6 mm interposed therebetween. Further, electrodes 12 (not shown in Fig. 1 but see Fig. 2) are provided in a region other than a region where the thermoelectric elements are bonded together with the insulating material 11 (in this example, on the upper and lower surfaces of the thermoelectric conversion module) so that the P-type thermoelectric conversion material 1 and the N-type thermoelectric conversion material 2 are electrically connected to each other in series. It is to be noted that the thermoelectric conversion module according to this example includes a total of 36 thermoelectric elements (6 rows and 6 columns).

However, the arrangement of the P-type thermoelectric conversion material 1 and the arrangement of the N-type thermoelectric conversion material 2, the number of the P-type thermoelectric conversion materials 1 used, and the number of the N-type thermoelectric conversion materials 2 used of the thermoelectric conversion module according to the present invention are not limited to those of this example.
Further, the arrangement or layout of the electrodes for connecting connecting each P-type thermoelectric conversion material 1 and each N-type thermoelectric conversion material 2 to each other in series is not particularly limited, either, and can be determined in consideration of the size and shape of each thermoelectric element used and the number of thermoelectric elements used.

As described above, the thermoelectric conversion module according to this example is formed by bonding the P-type thermoelectric conversion material 1 and the N-type thermoelectric conversion material 2 together with the insulating material 11 containing the spherical ceramic grains 11 a having a 3CV value of grain size of 20% or less (i.e., having a narrow grain size distribution). Therefore, as shown in Figs. 1 and 2, the bonding surfaces of the P-type thermoelectric conversion material 1 and the N-type thermoelectric conversion material 2 are allowed to be arranged substantially parallel to each other so as to be opposed to each other and spaced at substantially equal distance at all points. This makes it possible to arrange the P-type thermoelectric conversion material 1 and the N-type thermoelectric conversion material 2 with no space therebetween while reliably preventing the bonding surfaces of the P-type thermoelectric conversion material 1 and the N-type thermoelectric conversion material 2 from coming into direct contact with each other. As a result, it is possible to obtain a highly-reliable thermoelectric conversion module having a high occupancy of the thermoelectric conversion materials.

As described above, the bonding surfaces of the P-type thermoelectric conversion material 1 and the N-type thermoelectric conversion material 2 are allowed to be arranged substantially parallel to each other so as to be opposed to each other and spaced at substantially equal distances at all points. Therefore, a plurality of the P-type thermoelectric conversion material 1 and a plurality of the N-type thermoelectric conversion material 2 can be placed in proper alignment when each P-type thermoelectric conversion material 1 and each N-type thermoelectric conversion material 2 are bonded together with the insulating material 11 interposed therebetween. This makes it possible to obtain a highly-reliable thermoelectric conversion module having a higher occupancy of the thermoelectric conversion materials.

Hereinbelow, a method for producing the thermoelectric conversion module according to this example will be described.
La₂O₃, Nd₂O₃, CeO₂, SrCO₃, and CuO were prepared as raw material powders and weighed according to the predetermined compositions of (La_{1.98}Sr_{0.02})CUO₄ and (Nd_{1.98}Ce_{0.02})CuO₄ to obtain a P-type thermoelectric conversion material and an N-type thermoelectric conversion material, respectively.
In this case, oxides of La, Nd, Ce, and Cu and a carbonate of Sr were used as raw material powders. However, starting materials are not limited to oxides and carbonates such as those mentioned above, and may be other inorganic materials such as hydroxides or organic metal compounds such as acetylacetonato complexes.

The raw material powders weighed according to each of the compositions were milled and mixed in a wet ball mill using pure water as a solvent to obtain a slurry. Then, the slurry containing the raw material powders was evaporated to obtain a mixed powder.

Then, the thus obtained mixed powder was heated at 900°C for 8 hours in an air atmosphere to prepare a target oxide powder for thermoelectric conversion material. It is to be noted that at this time, unreacted part may remain.

An organic binder was mixed with each of the oxide powders for thermoelectric conversion material obtained by the heat treatment in an amount of 5 wt% with respect to the amount of each of the composition powders, and the resulting mixture was milled and mixed in a wet ball mill using pure water as a solvent.

Each of the composition powders containing the organic binder was sufficiency dried, and was then molded using a uniaxial pressing machine at a pressure of 10 MPa to prepare a molded body.

This molded body made of each of the oxide powders for thermoelectric conversion material was fired at 1000 to 1100°C for 2 hours in an air atmosphere to prepare a sintered product.
It is to be noted that the firing temperature at this time varies depending on the composition of each of the oxide powders for thermoelectric conversion material. Usually, conditions are set so that a relative density becomes 80% or higher (preferably 90% or higher).
As shown in Fig. 3, the thus obtained sintered products were cut into pieces each having a size of 5 mm x 5 mm x 5 mm by a dicing saw to obtain thermoelectric elements (P-type thermoelectric conversion material 1 and N-type thermoelectric conversion material 2).

Then, as shown in Table 1, three types of spherical zirconium oxide beads No. 1, No. 2, and No. 3 different in average grain size were prepared as spherical ceramic grains. It is to be noted that these spherical zirconium oxide beads are commercially available.
Then, the diameters of 100 beads of each of the three types of spherical zirconium oxide beads Nos. 1 to 3 were measured to determine an average grain size X, a standard deviation σ, and a 3CV value (= 3σ/X). The results are shown in Table 1.

**[Table 1]**

| Type of Beads | Average Grain Size (mm) | Standard Deviation of Grain Size (mm) | 3CV of Grain Size (%) |
|---|---|---|---|
| Spherical Zirconium Oxide Beads 1 | 0.54 | 0.034 | 19 |
| Spherical Zirconium Oxide Beads 2 | 0.12 | 0.0068 | 17 |
| Spherical Zirconium Oxide Beads 3 | 0.05 | 0.0032 | 19 |

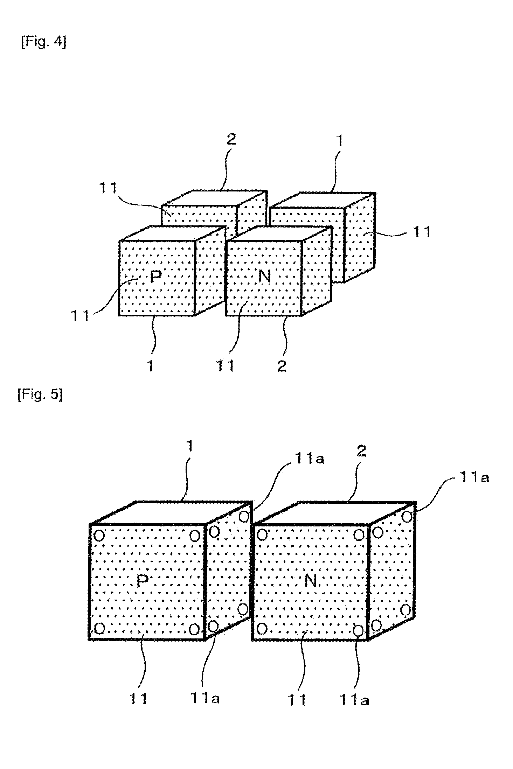

Then, as shown in Fig. 4, a glass paste (baked insulating material) 11 was applied onto four side surfaces other than conductive surfaces of each of the thermoelectric elements cut to a predetermined size.

Then, as shown in Fig. 5, at least one spherical zirconium oxide bead 11a was arranged in the four corners of each of the surfaces, onto which the glass paste 11 had been applied, before the glass paste 11 was dried.
Then, one surface of a thermoelectric element 1, on which the spherical zirconium oxide beads 11a had been arranged, was (temporarily) bonded to a bonding surface of another thermoelectric element 2, onto which the glass paste 11 had been applied. In this way, a pair of the P-type thermoelectric conversion material 1 and the N-type thermoelectric conversion material 12 was prepared. The pairs of the thermoelectric elements were arranged in such a manner as shown in Fig. 1, and all the thermoelectric elements were temporarily bonded together and dried in an oven at 150°C.

It is to be noted that the glass paste is not particularly limited as long as it can hold the spherical zirconium oxide beads (spherical ceramic grains), and it is preferred that the composition and concentration of the glass paste are appropriately selected depending on the type, size, and shape of spherical ceramic grains used.

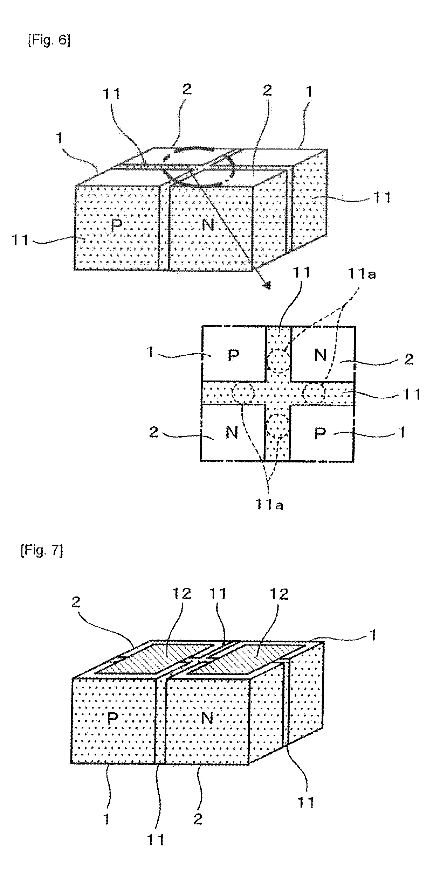

Then, a block obtained by bonding the thermoelectric elements (P-type thermoelectric conversion material 1 and N-type thermoelectric conversion material 2) together in such a manner as described above was introduced into a tunnel furnace heated at 900°C to melt a glass component constituting the insulating material in a nitrogen atmosphere. As a result, as shown in Fig. 6, the thermoelectric elements were bonded (coupled) together.

Then, surfaces as conductive surfaces, that is, upper and lower surfaces of the block obtained by bonding the thermoelectric elements together were polished.
As shown in Fig. 7, a Cu paste (electrodes 12 before firing) was applied onto the polished surfaces by screen printing to connect the thermoelectric elements (P-type thermoelectric conversion material 1 and N-type thermoelectric conversion material 2) to each other in series, and was then baked at 860°C in a nitrogen atmosphere. As a result, thermoelectric conversion modules (samples according to Examples 1 to 3 and Comparative Examples 1 to 3 shown in Table 2) in which, as shown in Fig. 1, the P-type thermoelectric conversion material 1 and the N-type thermoelectric conversion material 2 were connected to each other in series by the electrodes 12 (see Fig. 2) were prepared (in Fig. 1, the electrodes for connecting the P-type thermoelectric conversion material 1 and the N-type thermoelectric conversion material 2 to each other are not shown).

As shown in Table 2, the sample according to Example 1 used the spherical zirconium oxide beads No. 1 shown in Table 1 having an average grain size of 0.54 mm, a standard derivative of grain size of 0.034 mm, and a 3CV value of 19%.
The sample according to Example 2 used the spherical zirconium oxide beads No. 2 shown in Table 1 having an average grain size of 0.12 mm, a standard deviation of grain size of 0.0068 mm, and a 3CV value of 17%.
The sample according to Example 3 used the spherical zirconium oxide beads No. 3 shown in Table 1 having an average grain size of 0.05 mm, a standard deviation of grain size of 0.0032 mm, and a 3CV value of 19%.
The sample according to Comparative Example 1 was prepared by bonding the thermoelectric elements together with an insulating material made of only the glass paste without arranging spherical zirconium oxide beads (ceramic grains) on the glass paste.
Each of the samples according to Comparative Examples 2 and 3 used a mixture obtained by blending the spherical zirconium oxide beads Nos. 1 to 3 in a ratio shown in Table 2 to examine the influence of grain size dispersion of spherical ceramic grains.

The characteristics of the thus obtained samples were evaluated in the following manner.

### <Bondability>

The bondability between the thermoelectric elements and glass of each of the samples was evaluated by visual observation.
As a result, all the samples (thermoelectric conversion modules) according to Examples 1 to 3 and Comparative Examples 1 to 3 were free from detachment, cracking, or chipping due to tight bonding between the thermoelectric elements.

### <insulation between Thermoelectric Elements>

Insulation between the thermoelectric elements was evaluated by measuring the resistance between the thermoelectric elements.
The relationship between the properties (grain size and content rate) of the spherical zirconium oxide beads contained in the insulating material used in each of the samples and the resistance between the thermoelectric elements constituting the thermoelectric conversion module is shown in Table 2.

**[Table 2]**

| Samples | Blending Ratio of Spherical Zirconium Oxide Beads (wt%) | | | Resistance between Elements (Ω) |
|---|---|---|---|---|
| | Spherical Zirconium Oxide Beads 1 | Spherical Zirconium Oxide Beads 2 | Spherical Zirconium Oxide Beads 3 | |
| Sample of Example 1 | 100 | 0 | 0 | 105 - 106 |
| Sample of Example 2 | 0 | 100 | 0 | 104-105 |
| Sample of Example 3 | 0 | 0 | 100 | 107 - 108 |
| Sample of Comparative Example 1 | 0 | 0 | 0 | 0.1 - 1.0 |
| Sample of Comparative Example 2 | 90 | 5 | 5 | 0.1 - 1.0 |
| Sample of Comparative Example 3 | 50 | 45 | 5 | 0.1 - 1.0 |

As shown in Table 2, in the case of the sample according to Comparative Example 1 prepared without arranging spherical zirconium oxide beads on glass, the resistance between the thermoelectric elements was 0.1 to 1.0 Ω, that is, insulation between the thermoelectric elements was not ensured.

Also in the cases of Comparative Examples 2 and 3 using a mixture of the spherical zirconium oxide beads different in grain size, the resistance between the thermoelectric elements was 0.1 to 1.0 Ω, that is, insulation between the thermoelectric elements was not ensured. This is because bonding surfaces of the thermoelectric elements to be connected to each other are not arranged parallel to each other and therefore come into contact with each other at their ends.

Further, in the cases of Comparative Examples 2 and 3 using a mixture of the spherical zirconium oxide beads different in grain size, bonding surfaces of the thermoelectric elements were not arranged parallel to each other, and therefore the thermoelectric elements could not be placed in proper alignment. This is disadvantageous in that the occupancy of the thermoelectric elements is reduced.

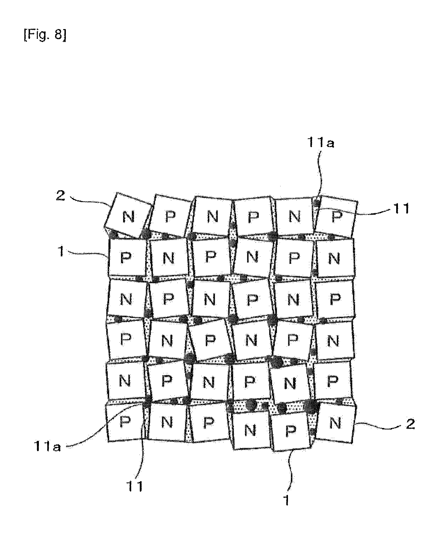

Fig. 8 is a plan view schematically showing the thermoelectric conversion module according to Comparative Example 3. As can be seen from Fig. 8, in a case where a mixture of the spherical zirconium oxide beads different in grain size was used, bonding surfaces of the thermoelectric elements (P-type thermoelectric conversion material 1 and N-type thermoelectric conversion material 2) were not arranged parallel to each other, and therefore the thermoelectric elements could not be placed in proper alignment. Therefore, the thermoelectric elements came into contact with each other, and therefore insulation between the thermoelectric elements was not ensured and, in addition, the occupancy of the thermoelectric elements was reduced.

On the other hand, in the cases of the samples (thermoelectric conversion modules) according to Examples 1 to 3 (see Figs. 1 and 2) using the insulating material containing any one of the three types of spherical zirconium oxide beads 1, 2, and 3 having a 3CV value (which is an index of grain size dispersion) of 20% or less to ensure insulation between the thermoelectric elements, the resistance between the thermoelectric elements was as high as 10⁴ to 10⁷ Ω, that is, good insulation between the thermoelectric elements was ensured.

Further, in the cases of the samples according to Examples 1 to 3, bonding surfaces of the thermoelectric elements were arranged parallel to each other, and therefore the thermoelectric elements could be placed in proper alignment so that a high occupancy of the thermoelectric elements was achieved.

It is to be noted that the present invention has been described with reference to the above example using spherical zirconium oxide beads as spherical ceramic grains. However, the spherical ceramic grains to be used in the preset invention are not particularly limited, and may be any spherical ceramic grains as long as they are made of a ceramic material such as alumina, titania, or the like.

Further, in the above example, insulating glass is used as an insulating material, but a resin-based material may be used as an insulating material instead of insulating glass.

It is to be noted that the present invention is not limited to the above example in other respects either. Various applications and modifications may be made within the scope of the present invention as regards, for example, the compositions and raw materials of the P-type thermoelectric conversion material and the N-type thermoelectric conversion material, the specific structure of the thermoelectric conversion module, and specific production conditions (e.g., sizes, firing conditions, the number of thermoelectric elements constituting the thermoelectric conversion module).

### INDUSTRIAL APPLICABILITY

As described above, according to the present invention, it is possible to obtain a highly-reliable thermoelectric conversion module which has a structure formed by bonding a P-type thermoelectric conversion material and an N-type thermoelectric conversion material together with an insulating material interposed therebetween, and is capable of reliably ensuring insulation between the bonding surfaces of the P-type thermoelectric conversion material and the N-type thermoelectric conversion material, and has a high occupancy of thermoelectric elements.
Therefore, the present invention can be widely applied to the field of thermoelectric conversion modules required to have a high occupancy of thermoelectric conversion elements and high reliability.

## Claims

1. A thermoelectric conversion module comprising:
a P-type thermoelectric conversion material;
an N-type thermoelectric conversion material; and
an insulating material containing spherical ceramic grains having a 3CV value, which is an index of particle size dispersion, of 20% or less, wherein the P-type thermoelectric conversion material and the N-type thermoelectric material are bonded together with the insulating material interposed therebetween, and wherein in a region other than a region where the P-type thermoelectric conversion material and the N-type thermoelectric conversion material are bonded together with the insulating material interposed therebetween, the P-type thermoelectric conversion material and the N-type thermoelectric conversion material are electrically connected to each other.

2. The thermoelectric conversion module according to claim 1, wherein the spherical ceramic grains have an average grain size of 0.05 to 0.6 mm.

3. The thermoelectric conversion module according to claim 1 or 2, wherein the insulating material is an insulating glass material.

4. A method for producing a thermoelectric conversion module comprising a P-type thermoelectric conversion material and an N-type thermoelectric conversion material which are bonded together with an insulating material interposed therebetween and are electrically connected to each other in a region other than a region where they are bonded together with the insulating material interposed therebetween, the method comprising the steps of:
preparing a P-type thermoelectric conversion material and an N-type thermoelectric conversion material;
applying an insulating material paste onto at least one of bonding surfaces of the P-type thermoelectric conversion material and the N-type thermoelectric conversion material to be bonded together with the insulating material interposed therebetween;
when the insulating material paste is applied onto both the bonding surfaces to be bonded together, attaching spherical ceramic grains having a 3CV value, which is an index of grain size dispersion, of 20% or less to at least one of the bonding surfaces so that the spherical ceramic grains are held by the insulating material paste, or when the insulating material paste is applied onto only one of the bonding surfaces to be bonded together, attaching spherical ceramic grains having a 3CV value, which is an index of grain size dispersion, of 20% or less to the one bonding surface onto which the insulating material paste is applied so that the spherical ceramic grains are held by the insulating material paste; and
sticking the P-type thermoelectric conversion material and the N-type thermoelectric conversion material together with the insulating material paste containing the spherical ceramic grains interposed therebetween and then bonding the P-type thermoelectric conversion material and the N-type thermoelectric conversion material together by thermal treatment.

5. The method for producing a thermoelectric conversion module according to claim 4, wherein the spherical ceramic grains have an average grain size of 0.05 to 0.6 mm.

6. The method for producing a thermoelectric conversion module according to claim 4 or 5, wherein the insulating material is an insulating glass material.
